# EUROPÄISCHE PATENTSCHRIFT

(11) **EP 4 078 123 B1**
(45) Veröffentlichungstag und Bekanntmachung des Hinweises auf die Patenterteilung: **19.03.2025**
(21) Anmeldenummer: 20812298.6
(22) Anmeldetag: 25.11.2020
(51) Int. Cl.: G01K 7/20, H05B 6/06, G01K 7/24, G01R 31/54, H05B 3/00, H05B 6/10, B05C 17/005, H05B 6/14

(54) **VORRICHTUNG ZUM VERSORGEN EINES MOBILEN MULTISCHMELZGERÄTES MIT HEIZLEISTUNG UND/ODER ZUR TEMPERATURMESSUNG**
APPARATUS FOR SUPPLYING A MOBILE MULTI-PURPOSE MELTING DEVICE WITH HEATING POWER AND/OR FOR MEASURING TEMPERATURE
APPAREIL POUR ALIMENTER UN DISPOSITIF DE FUSION POLYVALENT MOBILE EN ÉNERGIE DE CHAUFFAGE ET/OU MESURER UNE TEMPÉRATURE

(30) Priorität: 19.12.2019 DE 102019220199
(43) Veröffentlichungstag der Anmeldung: 26.10.2022
(73) Patentinhaber: Robert Bosch GmbH, 70442 Stuttgart (DE)
(72) Erfinder: WESSNER, Jochen, 73728 Esslingen (DE); KATZ, Martin, 70469 Stuttgart (DE); FABER, Marco, 70180 Stuttgart (DE); ETZEL, Timo, 73765 Neuhausen A.D.F. (DE); ROJO, Asmir, 72669 Unterensingen (DE); LUCIA GIL, Oscar, 50005 Zaragoza (ES); SARNAGO ANDIA, Hector, 50004 Zaragoza (ES)
(86) Internationale Anmeldenummer: PCT/EP2020/083301
(87) Internationale Veröffentlichungsnummer: WO 2021/121885

(56) Entgegenhaltungen:
- EP-A1- 0 190 452
- WO-A2-2018/178113
- US-A1- 2015 078 799

## Beschreibung

Die Erfindung betrifft eine Vorrichtung sowie ein Verfahren zum Erfassen einer Temperatur und/oder einer Heizleistung eines Multischmelzgerätes.

### Stand der Technik

Aus DE 10 2017 212 528 A1 ist eine Heißklebevorrichtung mit einem Heißklebestift bekannt. Die Heißklebevorrichtung weist einen Heißklebestift und eine externe, elektrische Heizstation auf. Die Heizstation ist ausgebildet, um den Heizklebestift mithilfe einer Induktivheizung aufzuheizen.

US 2015/078799 A1 offenbart ein induktionsgeheiztes Heizmodul für einen Heißschmelz-Applikatorstift, umfassend eine Temperaturmessschaltung.

EP 0 190 452 A1 offenbart eine Brückenschaltung zur Temperaturüberwachung eines Heißkleber-Auftragsystems.

### Offenbarung der Erfindung

Die Aufgabe der Erfindung besteht darin, eine verbesserte Vorrichtung zum Erfassen einer Temperatur und/oder einer Heizleistung eines Heizabschnittes des Multischmelzgerätes bereitzustellen.

Weiterhin besteht die Aufgabe der Erfindung darin, ein verbessertes Verfahren zum Erfassen einer Temperatur und/oder einer Heizleistung eines Heizabschnittes des Multischmelzgerätes bereitzustellen.

Die Aufgaben der Erfindung werden durch die unabhängigen Patentansprüche gelöst.

In den abhängigen Ansprüchen sind Weiterbildungen der Vorrichtung und des Verfahrens angegeben.

Es wird eine Vorrichtung zum Erfassen einer Temperatur und/oder einer Heizleistung eines

Multischmelzgerätes vorgeschlagen, wobei die Vorrichtung eine elektrische Schaltung aufweist, die ausgebildet ist, um die Temperatur des Multischmelzgerätes zu erfassen. Die die elektrische Schaltung ist ausgebildet, um mit einer weiteren elektrischen Schaltung des Multischmelzgerätes induktiv verbunden zu werden. Zudem weist die elektrische Schaltung eine Messschaltung auf, die ausgebildet ist, um einen Strom und/oder eine Spannung der elektrischen Schaltung zu messen. Weiterhin ist eine Auswerteschaltung vorgesehen, die ausgebildet ist, um abhängig von der gemessenen Spannung und/oder abhängig von dem gemessenen Strom die Temperatur des Multischmelzgerätes die Temperatur des Multischmelzgerätes zu ermitteln. Dabei ist die elektrische Schaltung ausgebildet, um das Multischmelzgerät induktiv mit Heizleistung zu versorgen, wobei die elektrische Schaltung einen Gleichrichter und einen Wechselrichter aufweist, wobei der Gleichrichter über zwei Busleitungen den Wechselrichter mit Strom versorgt, wobei der Wechselrichter ausgebildet ist, um eine Wechselspannung zum Versorgen einer Sendespule zu erzeugen, wobei die Auswerteschaltung die Spannung zwischen den Busleitungen erfasst, um eine auf das Multischmelzgerät übertragene Heizleistung und/oder eine Temperatur des Multischmelzgerätes abzuschätzen.

Dadurch, dass die elektrische Schaltung dazu ausgebildet ist, eine Heizleistung für das Multischmelzgerät bereitzustellen, wird ein kompakter Aufbau der elektrischen Schaltung mit geringem Schaltungsaufwand erreicht.

In einer Ausführung ist die Auswerteschaltung ausgebildet, um abhängig von einem zeitlichen Verlauf und/oder von einem minimalen Wert der gemessenen Spannung die induktiv übertragene Heizleistung und/oder die Temperatur des Multischmelzgerätes zu ermitteln.

Dadurch, dass die elektrische Schaltung induktiv mit einer elektrischen weiteren Schaltung koppelbar ist, wird eine einfache Verbindung zwischen der Vorrichtung und dem Multischmelzgerät ermöglicht.

In einem nicht erfindungsgemäßen Beispiel weist die elektrische Schaltung elektrische Kontakte auf, wobei mithilfe der elektrischen Kontakte eine direkte Verbindung zu weiteren elektrischen Kontakten der elektrischen weiteren Schaltung des Multischmelzgerätes herstellbar ist. Dadurch wird eine technisch einfache Verbindung realisiert.

In einer Ausführung weist die elektrische Schaltung wenigstens einen Messwiderstand zur Messung der Spannung und/oder des Stroms auf, wobei die elektrische Schaltung ausgebildet ist, um wenigstens einen Messwiderstand der elektrischen Schaltung zu ändern. Somit kann der Messbereich der Schaltung verändert werden.

In einer Ausführung ist die Auswerteschaltung ausgebildet, um abhängig von einer Änderung der Spannung zwischen den Busleitungen, insbesondere abhängig von einem zeitlichen Verlauf der Spannung, insbesondere abhängig von einer minimalen Spannung die übertragene Heizleistung und/oder die Temperatur des Multischmelzgerätes abzuschätzen.

In einer Ausführung weist der Wechselrichter eine erste Serienschaltung mit zwei Schaltern auf, wobei die erste Serienschaltung zwischen den zwei Schaltern eine zweite Ausgangsleitung aufweist, wobei die erste Serienschaltung nach dem zweiten Schalter eine dritte Ausgangsleitung aufweist, wobei die zweite Ausgangsleitung mit einem ersten Anschluss einer Spule verbunden ist, wobei die dritte Ausgangsleitung über einen Kondensator mit einem zweiten Anschluss der Spule verbunden ist.

In einer Ausführung weist der Wechselrichter eine erste Serienschaltung mit zwei Schaltern auf, wobei die erste Serienschaltung vor dem ersten Schalter eine dritte Ausgangsleitung aufweist, wobei die erste Serienschaltung zwischen den zwei Schaltern eine zweite Ausgangsleitung aufweist, wobei die erste Serienschaltung nach dem zweiten Schalter eine dritte Ausgangsleitung aufweist, wobei die zweite Ausgangsleitung mit einem ersten Anschluss einer Sendespule verbunden ist, wobei die erste und die dritte Ausgangsleitung mit einem zweiten Anschluss der Sendespule verbunden sind, wobei zwischen der ersten und der zweiten Ausgangsleitung eine Versorgungsschaltung ausgebildet ist, wobei die Versorgungsschaltung eine zweite Serienschaltung aufweist, wobei die zweite Serienschaltung einen ersten Kondensator und eine erste Diode aufweist, wobei die zweite Serienschaltung mit der ersten und der zweiten Ausgangsleitung verbunden ist, wobei zwischen dem Kondensator und der ersten Diode eine erste Versorgungsleitung angeschlossen ist, wobei die erste Versorgungsleitung an einen ersten Anschluss einer zweiten Diode angeschlossen ist, wobei eine Parallelschaltung mit einer Zenerdiode und einem zweiten Kondensator vorgesehen ist, wobei die Parallelschaltung mit einem ersten Anschluss an einen zweiten Anschluss der zweiten Diode angeschlossen ist, wobei die Parallelschaltung mit einem zweiten Anschluss an die erste Ausgangsleitung angeschlossen ist, wobei ein elektrischer Widerstand zwischen dem zweiten Anschluss der zweiten Diode und der dritten Ausgangsleitung geschaltet ist, wobei zwischen dem zweiten Anschluss der zweiten Diode und der ersten Ausgangsleitung eine Gleichspannung bereitgestellt wird.

Es wird Multischmelzgerät mit einer weiteren elektrischen Schaltung und einem induktiven Heizelement zum Erwärmen eines Schmelzmaterials vorgeschlagen, wobei die weitere elektrische Schaltung wenigstens einen Messwiderstand aufweist, der induktiv oder über die Kontakte mit einer elektrischen Schaltung einer erfindungsgemäßen Vorrichtung zum induktiven Versorgen eines mobilen Multischmelzgerätes mit Heizleistung und/oder zum Erfassen einer Temperatur des Multischmelzgerätes verbindbar ist.

Es wird ein Verfahren zum Erfassen einer Temperatur und/oder einer Heizleistung eines erfindungsgemäßen Multischmelzgeräts vorgeschlagen, wobei eine elektrische Schaltung in Wirkverbindung mit einer weiteren elektrischen Schaltung des Multischmelzgerätes gebracht wird, wobei ein Strom und/oder eine Spannung der elektrischen Schaltung erfasst wird, und wobei abhängig von der gemessenen Spannung und/oder abhängig von dem gemessenen Strom eine Temperatur des Multischmelzgerätes ermittelt wird.

Dabei versorgt die elektrische Schaltung das Multischmelzgerät induktiv mit Heizleistung, wobei die elektrische Schaltung einen Gleichrichter aufweist, wobei der Gleichrichter über zwei Busleitungen einen Wechselrichter mit Strom versorgt, wobei der Wechselrichter ausgebildet ist, um eine Wechselspannung zum Versorgen einer elektrischen Spule zu erzeugen, wobei die Spannung zwischen den Busleitungen erfasst wird, um abhängig von der Spannung die Temperatur des Multischmelzgerätes und/oder die auf das Multischmelzgerät übertragene Heizleistung abzuschätzen.

In einer Ausführung wird abhängig von einer Phasenverschiebung zwischen Strom und Spannung eine Temperatur des Multischmelzgerätes ermittelt wird.

In einer Ausführung wird ein Messwiderstand der elektrischen Schaltung verändert, um einen anderen Messbereich einzustellen.

Ausführungsbeispiele der Vorrichtung und des Verfahrens werden anhand von Figuren näher erläutert.

Es zeigen:
Fig. 1 eine perspektivische, teilgeschnittene Ansicht einer Vorrichtung zum Versorgen des mobilen Multischmelzgerätes mit Heizleistung und/oder zum Erfassen einer Temperatur eines Heizabschnittes des Multischmelzgerätes,
Fig. 2 eine schematische Darstellung eines Teilausschnittes einer elektrischen Schaltung der Vorrichtung,
Fig. 3 eine schematische Darstellung eines gemessenen Stromverlaufes und eines gemessenen Spannungsverlaufes,
Fig. 4 eine schematische Darstellung eines Teilquerschnittes einer Ausführungsform der Vorrichtung und eines Teilquerschnittes einer Ausführungsform des Multischmelzgerätes,
Fig. 5 eine schematische Darstellung eines Teilausschnittes einer elektrischen Schaltung der Vorrichtung,
Fig. 6 ein elektrisches Ersatzschaltbild einer elektrischen Schaltung der Vorrichtung für ein induktives Heizen des Multischmelzgerätes,
Fig. 7 ein Messdiagramm, bei dem die gemessene Spannung über die Zeit mit und ohne einem induktiv zu heizenden Multischmelzgerät,
Fig. 8 eine schematische Darstellung eines elektrischen Ersatzschaltbildes einer weiteren Ausführungsform der elektrischen Schaltung der Vorrichtung mit einer Gleichstromquelle, und
Fig. 9 eine schematische Darstellung eines Diagramms zum Betreiben der Ausführungsform der Fig. 8.

### Beschreibung der Ausführungsbeispiele

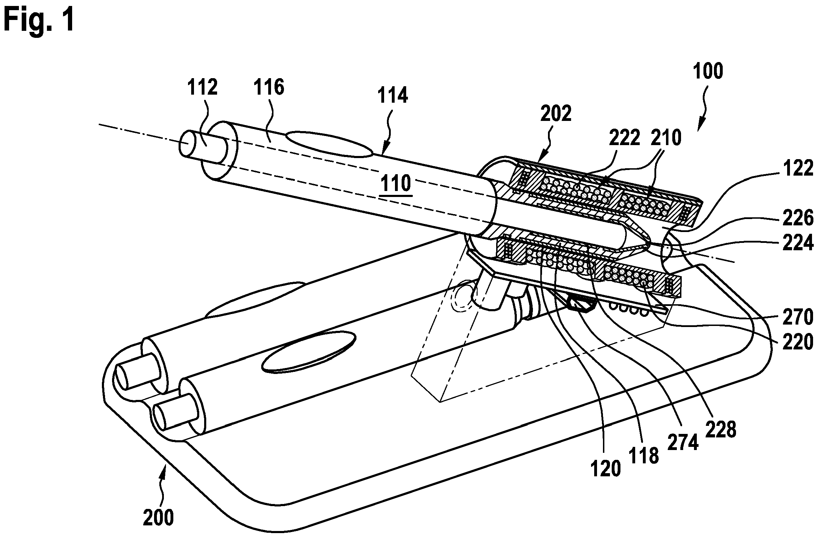

Fig. 1 zeigt in einer schematischen Darstellung eine Multischmelzvorrichtung 100 mit einer Heizstation 200. Die Heizstation 200 weist eine Halterung 202 auf, in die beispielhaft ein schnurloses, mobiles Multischmelzgerät 110 eingesteckt ist. Das Multischmelzgerät 110 kann beispielsweise in Form eines Heißklebestiftes ausgebildet sein und mit einem Materialstift 112 bzw. in Form einer Klebepatrone bestückt sein. Der Materialstift 112 kann zum Beispiel mit einem hergebrachten Schmelzkleber gebildet sein, der bei Raumtemperatur eine feste Konsistenz aufweist und beim Erreichen einer Verarbeitungstemperatur beispielsweise in einem Bereich von 160°C bis 200°C aus dem festen Zustand in einen zähfließend pastösen, klebefähigen Zustand übergeht. Vorzugsweise verbleibt der Schmelzkleber bzw. Schmelzkunststoff nach dem Erreichen der Verarbeitungstemperatur auch ohne weitere Wärmezufuhr für einen Zeitraum von 5 bis 90 s verarbeitungsfähig. Abhängig von der gewählten Ausführungsform kann das Multischmelzgerät 110 auch andere Arten von Materialien, insbesondere Kunststoffe in Form eines Materialstifts aufweisen, die mithilfe einer erhöhten Temperatur von einem festen in einen zähfließend pastösen Zustand übergeführt werden können.

Zudem kann abhängig von der gewählten Ausführungsform das Multischmelzgerät 110 mit einem Materialstift beispielsweise aus verschiedenen Arten von Schmelzklebern, Spezialwachsen oder dergleichen in jeweils unterschiedlichen Farben, Lichtdurchlässigkeitsstufen, Schmelztemperaturen, Festigkeiten usw. versehen sein. Zudem können die Materialien der Materialstifte unterschiedliche Feststoffpartikel und/oder Füllpartikel, wie z.B. Glitzerpartikel, Mikrokristalle, Metallfolienpartikel usw. aufweisen.

Die Heizstation 200 verfügt über eine berührungslose, elektrische Induktivheizung 210. Die Induktivheizung 210 ist ausgebildet, um zumindest bereichsweise das Multischmelzgerät 110 berührungslos aufzuheizen. Die Induktivheizung 210 ermöglicht im Vergleich zu konventionellen Widerstandsheizelementen kurze Aufheizphasen, eine gezielte Erwärmung, sowie eine gute Regeldynamik bei einem deutlich erhöhten Wirkungsgrad. Weiterhin lassen sich auf einfache Art und Weise unterschiedliche Heizzonen durch inhomogene Magnetfelder, zum Beispiel zum Vorwärmen und Aufschmelzen der Materialstifts einrichten. Die Induktivheizung 210 ermöglicht darüber hinaus eine kompakte, stiftähnliche Bauform der Multischmelzgeräte 110, wobei dessen Stiftgehäuse dennoch thermisch gut isolierbar bzw. einkapselbar ist, um insbesondere eine Verbrennungsgefahr für den Anwender auszuschließen. Das Multischmelzgerät 110 verfügt über ein zumindest im Wesentlichen stabförmiges Stiftgehäuse 114 und einen hohlzylindrischen Zuführungsabschnitt 116 für den Materialstift 112. An den Zuführungsabschnitt 116 schließt sich axial ein Halteabschnitt 118 zum Angreifen durch den Anwender an. Der Halteabschnitt 118 ist unter Schaffung eines schmalen Ringspalts 120 in einem Aufnahmeschacht 122 der Halterung 202 der Heizstation 200 aufnehmbar. Ein axialer Vorschub des Materialsticks 112 kann zum Beispiel durch anwenderseitiges Eindrücken erfolgen. Alternativ kann eine mechanische Vorschubeinrichtung vorgesehen sein, die jeweils mittels mindestens eines Fingers des Anwenders im Bereich der jeweiligen Halteabschnitte des Multischmelzgerätes 110 betätigbar ist.

In der Heizstation 200 ist eine Steuereinrichtung 270 integriert, die ein Steuergerät und eine elektrische Schaltung aufweist. Die Steuereinrichtung 270 kann drahtlos oder über eine Kontaktbuchse mit einer externen Recheneinheit wie beispielsweise einem PC, einem Computer-Tablet oder einem Smartphone verbunden sein. Die Heizstation 200 kann über ein Netzkabel oder netzunabhängig über Batterien mit Strom versorgt werden.

Die Induktivheizung 210 umfasst beispielsweise eine erste Heizwicklung 220 zum endseitigen Aufschmelzen des Materialstifts, sowie eine zweite Heizwicklung 222 zum Vorwärmen des Materialstifts 112. Anstelle von zwei elektrisch getrennten Heizwicklungen 220, 222 kann auch lediglich eine Heizwicklung vorgesehen sein. Zudem kann die eine Heizwicklung abschnittsweise unterschiedliche Wicklungsdichten zur Erzeugung eines inhomogenen Magnetfelds aufweisen. Die erste Heizwicklung 220 wirkt mittels eines magnetischen Wechselfeldes mit einer metallischen Heizdüse 224 zusammen, die an einem vorderen Ende im Multischmelzgerät 110 angeordnet ist. Die Heizdüse 224 weist eine im Wesentlichen hohlkegelige Formgebung auf, wobei eine endseitige, düsenartige Austrittsöffnung 226 im Bereich einer Kegelspitze vorgesehen ist. Die zweite Heizwicklung 222 ist durch ein magnetisches Wechselfeld mit einer metallischen, hohlzylindrischen Vorheizhülse 228 gekoppelt. Mithilfe der beiden Heizwicklungen 220, 222 werden jeweils Wirbelströme in der Heizdüse 224 bzw. in der Vorheizhülse 226 induziert, die aufgrund der darin auftretenden ohmschen Verluste zu einer gewünschten, definierten Temperaturerhöhung der Heizdüse 224 und der Vorheizhülse 226 führen. Zur Erzeugung der notwendigen magnetischen Wechselfelder werden die Heizwicklungen 220, 222 mittels der elektrischen Steuereinrichtung 270 mit einem Strom mit einem geeigneten zeitlichen Verlauf, insbesondere Frequenz, Amplitude und Kurvenform beaufschlagt. Abhängig von der gewählten Ausführungsform können die Heizdüse 224 und die Vorheizhülse 226 aus einem ferromagnetischen Material gebildet sein wie zum Beispiel Eisen, Stahl usw. In dieser Ausführungsform wird die Temperaturerhöhung in der Heizdüse und der Vorheizhülse durch Auftreten der Hystereseverluste erwärmt.

Das aufgeheizte Multischmelzgerät 110 kann aus der Halterung 202 entnommen werden und ein Anwender kann das aufgeschmolzene bzw. verflüssigte Material des Materialstiftes 112, das durch die Austrittsöffnung 226 im Bereich der Heizdüse 224 austritt, exakt dosieren und einem zu bearbeitenden Werkstück zu führen. Das Multischmelzgerät 110 kann anstelle der dargestellten Stiftform auch in Form einer Heißschmelzpistole ausgebildet sein und einen entsprechenden Griff und Betätigungselemente aufweisen.

Zudem kann das Multischmelzgerät 110 anstelle der beschriebenen Heizdüse 224 und Vorheizhülse 228 auch anders geformte induktiv aufheizbare Heizelemente aufweisen, mit denen der Materialstift 112 erwärmt und insbesondere verflüssigt werden kann.

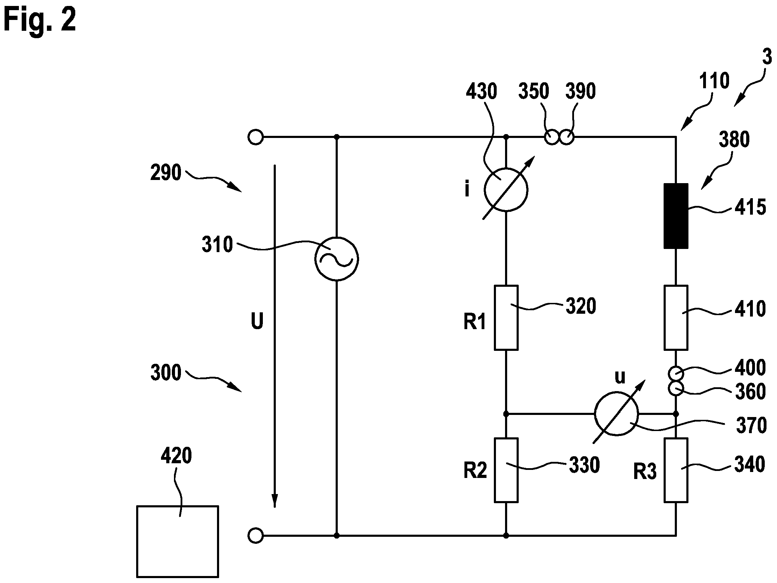

In einem nicht erfindungsgemäßen Beispiel weist die elektrische Schaltung 290 der Steuereinrichtung 270 eine Messschaltung 300 auf, die in Fig. 2 schematisch dargestellt ist. Die Messschaltung 300 weist eine Wechselspannungsquelle 310, eine Serienschaltung mit einem ersten Widerstand 320 und einem zweiten Widerstand 330 auf. Zudem ist parallel zum zweiten elektrischen Widerstand 330 ein dritter elektrischer Widerstand 340 vorgesehen. Weiterhin weist die Messschaltung 200 einen ersten elektrischen Kontakt 350 auf, der mit der Verbindungsleitung von der Wechselspannungsquelle mit dem ersten elektrischen Widerstand 320 verbunden ist. Weiterhin ist ein zweiter elektrischer Kontakt 360 am zweiten Anschluss des vierten elektrischen Widerstandes ausgebildet. Zudem ist zwischen dem zweiten elektrischen Kontakt 360 und der Verbindungsleitung vom ersten elektrischen Widerstand 320 und dem zweiten elektrischen Widerstand 330 ein Spannungsmessgerät 370 geschaltet.

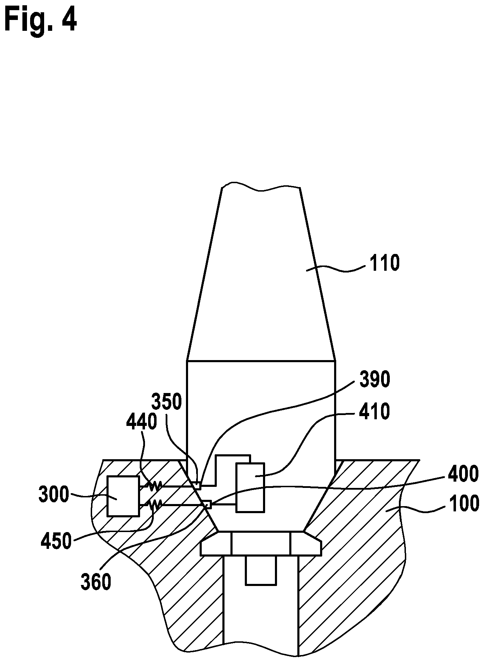

Zudem ist schematisch in Fig. 2 eine weitere elektrische Schaltung 380 dargestellt, die im Multischmelzgerät 110 angeordnet ist. Dazu weist das Multischmelzgerät 110 weitere erste und zweite elektrische Kontakte 390, 400 auf. Die weitere elektrische Schaltung 380 weist einen temperaturabhängigen Messwiderstand 410 und eine elektrische Spule 415 auf. In der dargestellten Ausführungsform ist der weitere erste elektrische Kontakt 390 in direktem Kontakt mit dem ersten elektrischen Kontakt 350. Der weitere zweite elektrische **Kontakt 400** ist in direktem Kontakt mit dem zweiten elektrischen Kontakt 360, wie schematisch in Fig. 4 dargestellt ist.

Für einen optimalen Betrieb des Multischmelzgerätes 110 ist es vorteilhaft, die Temperatur im Multischmelzgerät 110 zu bestimmen. Die Bestimmung der Temperatur kann durch eine Spannungsmessung mithilfe des Spannungsmessgerätes 370 mithilfe der Messschaltung 300 und dem temperaturempfindlichen Messwiderstand 410 erfolgen. Dabei wird eine Messbrücke verwendet, wobei ein Teil der Messbrücke aus dem Messwiderstand 410 des Multischmelzgerätes 110 besteht. Der Messwiderstand 410 ist in der Weise ausgebildet, dass sein ohmscher Widerstand z.B. linear von der Temperatur abhängt. Abhängig von der gewählten Ausführungsform kann der ohmsche Widerstand des Messwiderstandes 410 auch eine nichtlineare Abhängigkeit aufweisen, die z.B. als Kennfeld in einem Datenspeicher einer Steuereinheit 420 abgelegt sein. Der Messwiderstand 410 ist vorzugsweise im Bereich der Heizdüse 224 im Multischmelzgerät angeordnet.

Zudem ist die Steuereinheit 420 vorgesehen, die beispielsweise die Wechselspannungsquelle 310 ansteuert, um eine gewünschte Spannung und/oder einen gewünschten Strom bereitzustellen. Weiterhin steht die Steuereinheit 420 mit dem Spannungsmessgerät 370 in Verbindung. Zudem ist in der Serienschaltung des ersten und des zweiten Widerstandes eine Strommesseinrichtung 430 vorgesehen, die ebenfalls mit der Steuereinheit 420 in Verbindung steht.

Die Steuereinheit 420 gibt mithilfe der Wechselspannungsquelle 310 einen vorgegebenen Spannungsverlauf beispielsweise in Form eines sinusförmigen Spannungsverlaufes vor. Gleichzeitig wird mithilfe des Spannungsmessgerätes 370 die Spannung und mithilfe der Strommesseinrichtung 430 der Strom gemessen. Abhängig von der Temperatur des Multischmelzgerätes 110 werden unterschiedliche Spannungen vom Spannungsmessgerät gemessen. Zudem beeinflusst der Widerstand des Messwiderstandes 410 eine Phasenverschiebung Φ zwischen der gemessenen Spannung und dem gemessenen Strom. Die Steuereinheit 420 verfügt über den Datenspeicher, in dem für die gemessenen Spannungen bzw. die gemessene Phasenverschiebung zwischen Strom und Spannung entsprechende Temperaturen des Multischmelzgerätes 110 abgespeichert sind.

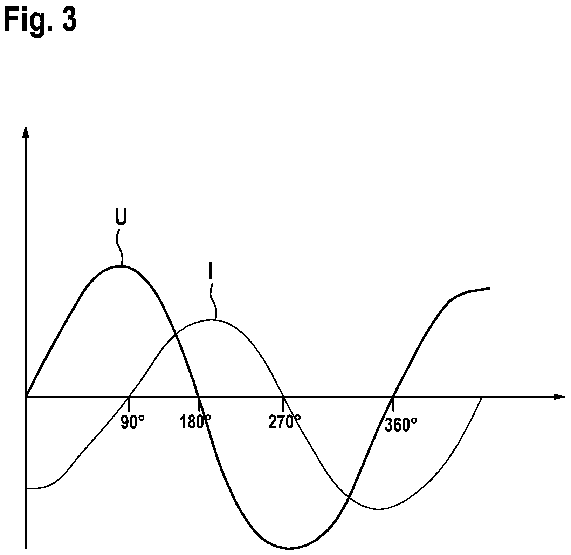

Fig. 3 zeigt in einer schematischen Darstellung ein Diagramm über den Verlauf der gemessenen Spannung U und den Verlauf des gemessenen Stromes I über einen Phasenwinkel, der entlang der X-Achse aufgetragen ist.

Fig. 4 zeigt in einer schematischen Darstellung einen Teilausschnitt eines nicht erfindungsgemäßen Beispiels der Anordnung der Fig. 1 und 2 mit einer Multischmelzvorrichtung 100 zum Versorgen des mobilen Multischmelzgerätes 110 mit Heizleistung und/oder zum Erfassen einer Temperatur eines Heizabschnittes des Multischmelzgerätes und dem Multischmelzegrät. Bei dieser Ausführungsform ist der erste elektrische Kontakt 350 mithilfe einer ersten mechanischen Feder 440 in Richtung auf das Multischmelzgerät 110 federnd vorgespannt. Zudem ist der zweite elektrische Kontakt 360 mithilfe einer zweiten mechanischen Feder 450 ebenfalls federbelastet in Richtung auf das Multischmelzgerät 110 vorgespannt. Das Multischmelzgerät 110 weist den weiteren ersten elektrischen Kontakt 390 auf, der direkt an dem ersten elektrischen Kontakt 350 anliegt. Weiterhin weist das Multischmelzgerät 110 den weiteren zweiten elektrischen Kontakt 400 auf, der auf dem zweiten elektrischen Kontakt 360 anliegt. Durch die Federbelastung der elektrischen Kontakte wird ein verbesserter elektrischer Kontakt zwischen der Heizstation 200 und dem Multischmelzgerät 110 erreicht.

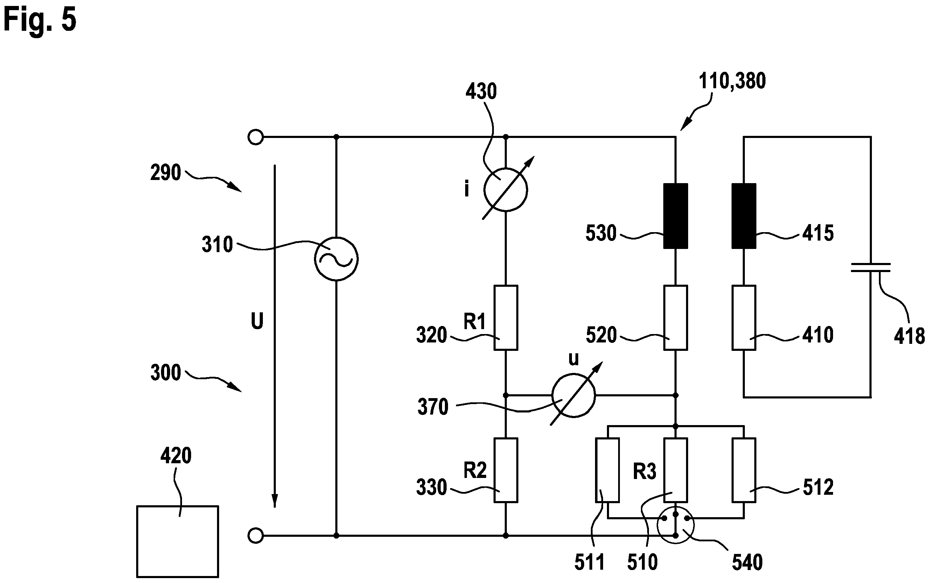

Fig. 5 zeigt in einer schematischen Darstellung eine weitere Ausführungsform einer Messschaltung 300, die ähnlich der Messschaltung 300 der Fig. 2 aufgebaut ist. Bei dieser Ausführungsform sind jedoch parallel zum ersten und zum zweiten elektrischen Widerstand 320, 330 eine Serienschaltung eines dritten elektrischen Widerstandes 510, eines vierten elektrischen Widerstandes 520 und einer Sendespule 530 angeordnet. Das Spannungsmessgerät 370 ist zwischen den Verbindungsleitungen zwischen dem ersten elektrischen Widerstand und dem zweiten elektrischen Widerstand 320, 330 und zwischen der Verbindungsleitung zwischen dem dritten elektrischen Widerstand und dem vierten elektrischen Widerstand 510, 520 geschaltet. Bei dieser Ausführungsform wird eine induktive Kopplung zwischen der Messschaltung 300 und dem Messwiderstand 410 des Multischmelzgerätes 110 erreicht. Dazu weist das Multischmelzgerät 110 eine Serienschaltung aus dem Messwiderstand 410, einer Messspule 415 und einem Messkondensator 418 auf, die einen Resonanzkreis bilden. Die induktive Kopplung erfolgt über die Sendespule 530 und die Messspule 415.

Die Strommesseinrichtung 430 ist zwischen der Wechselspannungsquelle 310 und der Parallelschaltung der zwei Serienschaltungen angeordnet. Die Spannung im Messpfad der Messschaltung wird durch die induktive Kopplung zwischen den zwei Spulen 530, 415 erreicht. Auch bei dieser Ausführungsform wird die Spannung abhängig von der Temperatur des Messwiderstandes 410 beeinflusst. Die Steuereinheit 420 ist mit der Wechselspannungsquelle 310 und mit der Strommesseinrichtung 430 und mit dem Spannungsmessgerät 370 verbunden. Zudem verfügt die Steuereinheit 420 über einen Datenspeicher, in dem Referenzwerte für die Temperaturwerte des Multischmelzgerätes für die gemessenen Spannungen, Ströme und/oder Phasenverschiebungen zwischen den gemessenen Spannungen und Strömen abgelegt sind. Somit kann die Steuereinheit 420 mithilfe der abgespeicherten Referenzwerte anhand der gemessenen Spannungen, Ströme und/oder Phasenverschiebungen zwischen den Spannungen und Strömen die Temperatur des Multischmelzgerätes abschätzen.

Zudem führt die induktive Kopplung mit der weiteren Messschaltung des Multischmelzgerätes 110 abhängig von der Temperatur des Messwiderstandes 410 zu einer Phasenverschiebung zwischen der Spannung und dem Strom in der Messschaltung der Heizstation. Mithilfe dieser Anordnung kann die Temperatur des Multischmelzgerätes 110 kontaktlos gemessen werden.

Abhängig von der gewählten Ausführungsform kann die Messschaltung 300 einen Schalter 540 aufweisen, der drei verschieden große dritte elektrische Widerstände 510, 511, 512 in die zweite Serienschaltung schalten kann. Der Schalter 540 kann von der Steuereinheit 420 oder direkt von einer Bedienperson geschaltet werden. Der Schalter 540 kann als Drehregler 540 ausgebildet sein. Somit kann der Arbeitsbereich der Messschaltung stufenweise eingestellt werden. Dadurch können verschiedene Materialien verarbeitet werden. Die stufenweise Einstellung kann optional auch stufenlos durch einen Drehregler erfolgen.

Die induktive Kopplung ermöglicht auch die Auswertung mittels der Verschiebung der Resonanzfrequenz des Systems. Die Resonanzfrequenz des Systems verschiebt sich mit der Temperatur. Die Resonanzfrequenz wird gemessen. Zudem verfügt die Steuereinheit 420 über einen Datenspeicher, in dem zu Resonanzfrequenzen Temperaturen des Multischmelzgerätes abgelegt sind. Somit kann aufgrund der Resonanzfrequenz die Temperatur des Multischmelzgerätes ermittelt werden. Beispielsweise kann die Auswertung über ein Bode-Diagramm anhand eines Vorzeichenwechsels von plus nach minus in der Steigung des Amplitudenspektrums detektiert werden.

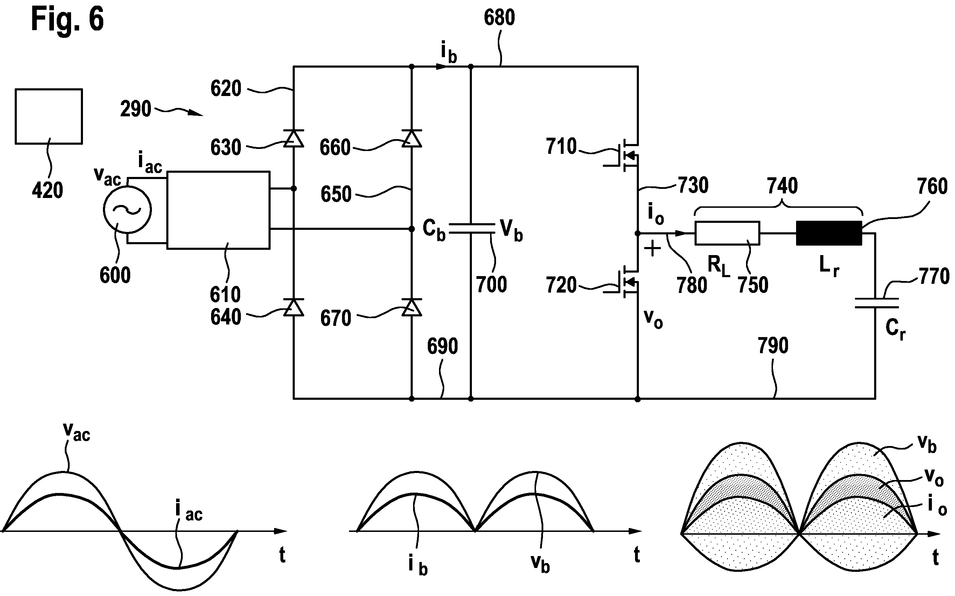

Fig. 6 zeigt in einer schematischen Darstellung ein elektrisches Ersatzschaltbild für eine elektrische Schaltung 290 einer induktiven Heizung der Heizstation 200. Von einer zweiten Wechselspannungsquelle 600 wird eine Wechselspannung v_{ac} mit einem Strom i_{ac} über einen EMC-Filter 610 an eine Parallelschaltung einer ersten Serienschaltung 620 mit einer ersten und einer zweiten Diode 630, 640 und einer zweiten Serienschaltung 650 einer dritten und einer vierten Diode 660, 670 geführt. Die erste und die zweite Serienschaltung 620, 650 sind mit einer ersten Busleitung 680 und einer zweiten Busleitung 690 verbunden. Die erste und die zweite Serienschaltung 620, 650 stellen einen Brückengleichrichter dar, der die Wechselspannung der Wechselspannungsquelle 600 in positive Spannungen auf der ersten Busleitung 680 transferiert wird. Zwischen der ersten und der zweiten Busleitung 680, 690 ist ein erster Kondensator 700 geschaltet. Auf der ersten Busleitung 680 fließt der Strom i_{b} und am ersten Kondensator 700 liegt die Spannung v_{b} an. Zudem sind Strom- und Spannungsmessgeräte vorgesehen, mit denen der Strom i_{b} der ersten Busleitung 680 und die am ersten Kondensator 700 anliegende Spannung v_{b} gemessen werden. Die Strom- und Spannungsmessgeräte sind nicht dargestellt.

Die erste Busleitung 680 und die zweite Busleitung 690 sind über eine Serienschaltung aus einem ersten Schalter 710 und einem zweiten Schalter 720 verbunden. Der erste und der zweite Schalter 710, 720 werden von der Steuereinheit 420 geschaltet. Der erste und der zweite Schalter 710, 720 sind beispielsweise als Feldeffekt-Transistoren ausgebildet. Der erste und der zweite Schalter 710, 720 sind über eine Verbindungsleitung 730 miteinander verbunden. Die Verbindungsleitung 730 steht über eine erste Ausgangsleitung 780 mit einer zweiten Sendespule 740 in Verbindung, die schematisch in Form eines ohmschen Widerstandes 750 und eines induktiven Widerstandes 760 dargestellt ist. Auf der ersten Ausgangsleitung 780 fließt der Strom iₒ. Ein zweiter Anschluss der Sendespule 740 ist über einen weiteren Kondensator 770 mit der zweiten Busleitung 790 verbunden. Am weiteren Kondensator 770 liegt eine Spannung v_{c} an. Die Serienschaltung mit dem ersten und dem zweiten Schalter 710, 720 stellt eine Wechselspannung vₒ über die Ausgangsleitung 780 und die zweite Ausgangsleitung 790 bereit.

Für hohe Spannungen zwischen der ersten und der zweiten Busleitung 780, 790 ist es vorteilhaft, den ersten Kondensator 700 mit einer niedrigen Kapazität zu wählen. In diesen Systemen ist es jedoch vorteilhaft, das Vorhandensein einer induktiven Last an der Sendespule 740 und die Abschätzung der von der Sendespule 740 abgegebenen induktiven Heizleistung zu ermitteln.

In Fig. 6 sind schematisch die Strom- und Spannungsverläufe dargestellt, wobei v_{ac} die Spannung am Ausgang der Wechselspannungsquelle 600, i_{ac} der Strom am Ausgang der Wechselspannungsquelle 600, v_{b} die Spannung am ersten Kondensator 700, i_{b} der Stromfluss über die erste Busleitung 680, iₒ der Stromfluss über die erste Ausgangsleitung 780, v_{c} die Spannung am zweiten Kondensator 750 und vₒ die Spannung zwischen der ersten und der zweiten Ausgangsleitung 780, 790 bezeichnen.

Die Steuereinheit 420 ist ausgebildet, um mit dem nicht dargestellten Spannungsmessgerät die Busspannung v_{b} am ersten Kondensator 700 zu detektieren. Abhängig von der gemessenen Busspannung kann das Vorhandensein einer induktiven Last detektiert werden. Zudem kann mithilfe der gemessenen Busspannung die mithilfe der Sendespule übertragene Heizleistung abgeschätzt werden. Somit kann anhand der Busspannung und der Zeitdauer, während der Heizleistung induktiv an das Multischmelzgerät übertragen wird, die Temperatur des Multischmelzgerätes abgeschätzt werden. Dazu sind entsprechende, experimentell ermittelte Werte in einem Datenspeicher der Steuereinheit 420 abgelegt, die abhängig von einer minimalen Busspannung das Vorhandensein einer induktiven Last, d.h. eines Multischmelzgerätes darstellen. Zudem sind im Datenspeicher Werte für die übertragene induktive Heizleistung abhängig von der minimalen Busspannung und vom gemessenen Strom auf der ersten Busleitung abgespeichert. Zudem sind im Datenspeicher Werte für die Temperatur des Multischmelzgerätes abhängig von der minimalen Busleitung und/oder vom Strom auf der ersten Busleitung und/oder von der Zeitdauer der Bestromung der Sendespule im Datenspeicher abgelegt.

Versuche haben gezeigt, dass die die Busspannung v_{b} abhängig von dem Vorhandensein einer induktiven Last bzw. abhängig von der gesendeten Sendeleistung der Sendespule 740 und damit abhängig von der übermittelten Heizleistung verändert. Die Steuereinheit 420 verfügt über einen Datenspeicher, in dem für die Busspannungen Referenzwerte für die übertragene Heizleistung und die Temperatur des Multischmelzgerätes abgelegt sind. Somit kann die Steuereinheit 420 aufgrund der Busspannung und/oder dem Strom der ersten Busleitung und/oder der Zeitdauer der Bestromung der Sendespule 740 die Temperatur des Multischmelzgerätes abschätzen und ermitteln.

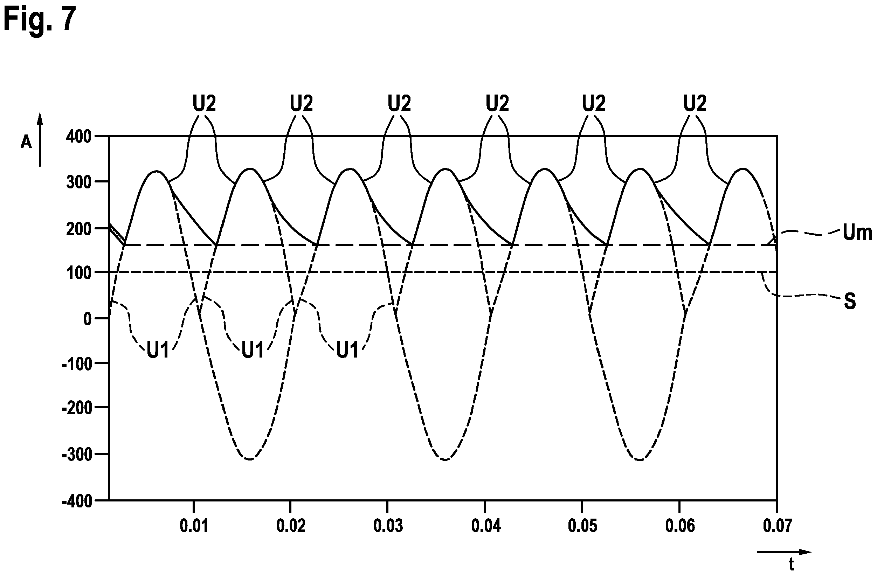

Fig. 7 zeigt in einer schematischen Darstellung ein Diagramm für mehrere gemessene Busspannungen. In dem Diagramm ist die Amplitude A der Busspannung in Volt über die Zeit aufgetragen. Die gemessene Busspannung v_{b} ist in einer gestrichelten Linie dargestellt und mit U1 für den Fall bezeichnet, dass keine induktive Last, das heißt kein Multischmelzgerät 110 in der Nähe der Heizstation 200 zum Empfangen einer induktiven Heizleistung vorgesehen ist. Dabei ist erkennbar, dass die Busspannung immer wieder den Wert von 0 V erreicht.

Ist dagegen eine induktive Last vorhanden, das heißt ein Multischmelzgerät 110 an der Heizstation 200 angeordnet, so sinkt die mit U2 bezeichnete Busspannung v_{b} nicht bis auf 0 V ab, sondern schwingt zwischen Werten von beispielsweise mehr als 100 V und der maximalen Spannung von 360 V hin und her, wie mit der zweiten Kennlinie U2, die als durchgezogene Linie dargestellt ist, gezeigt wird. Somit stellt in diesem Fall 100 Volt eine minimale Busspannung Um dar, wie in Fig. 7 eingezeichnet. Das Steuereinheit 420 verfügt über einen Datenspeicher, in dem für minimale Busspannungen Um Referenzwerte für die übertragene Heizleistung und die Temperatur des Multischmelzgerätes abgelegt sind. Somit kann die Steuereinheit 420 aufgrund der Busspannung und/oder dem Strom der ersten Busleitung und/oder der Zeitdauer der Bestromung der Sendespule 740 die Temperatur des Multischmelzgerätes abschätzen und ermitteln.

Zudem kann beispielsweise ein Schwellwert S von beispielsweise 100 V festgelegt werden. Unterschreitet die Busspannung den Schwellwert nicht, so erkennt das Steuergerät 420 das Vorliegen einer induktiven Last, das Vorhandensein eines Multischmelzgerätes im Umfeld der Sendespule. Die Busspannung kann beispielsweise mit einem analogen Komparator oder einem HD-Konverter gemessen werden. Zudem können im Datenspeicher der Steuereinheit 420 Vergleichskennlinien oder Schwellwerte für die gemessene Busspannung abgelegt sein, denen aufgrund von vorher durchgeführten Versuchen die auf das Multischmelzgerät 110 übermittelte Heizleistung und/oder Temperatur des Multischmelzgerätes zugeordnet sind. Beispielsweise ist die übertragene Heizleistung umso größer, je größer der maximale Schwellwert ist, den die Busspannung nicht unterschreitet.

Auf diese Weise kann die Steuereinheit 420 anhand der gemessenen Busspannung v_{b} die übertragene Heizleistung und damit die im Multischmelzgerät 110 herrschende Temperatur abschätzen. Der abgeschätzte Wert der Temperatur des Multischmelzgerätes 110 kann dazu verwendet werden, um die ausgesendete induktive Heizleistung in der Weise anzupassen, dass das Multischmelzgerät 110 im Bereich der Heizdüse eine vorgegebene Temperatur aufweist. Dazu sind entsprechende experimentell ermittelte Werte im Datenspeicher der Steuereinheit 420 abgelegt.

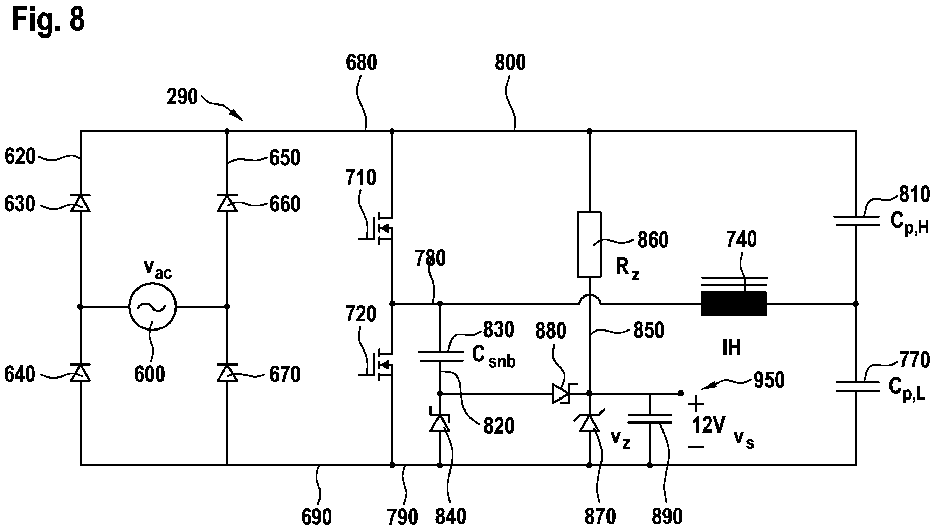

Fig. 8 zeigt eine weitere Ausführungsform einer elektrischen Schaltung 290 der Heizstation 200. Die elektrische Schaltung entspricht im Wesentlichen der Schaltung der Fig. 6, wobei jedoch zusätzlich eine Versorgungsschaltung 950 für eine Gleichspannung vorgesehen ist. Dazu weist die Schaltung eine dritte Ausgangsleitung 800 auf, die von der ersten Busleitung 680 über einen dritten Kondensator 810 zum zweiten Anschluss der Sendespule 740 geführt ist.

Weiterhin ist eine weitere Serienschaltung 820 bestehend aus einem dritten Kondensator 830 und einer fünften Diode 840 vorgesehen, wobei die fünfte Diode 840 und der vierte Kondensator 830 zwischen der ersten und der zweiten Ausgangsleitung 780, 790 geschaltet sind. Weiterhin ist eine zusätzliche Serienschaltung 850 vorgesehen, die einen siebten Widerstand 860 und eine Zenerdiode 870 aufweist. Die zusätzliche Serienschaltung 850 ist zwischen der dritten Ausgangsleitung 800 und der ersten Ausgangsleitung 790 angeordnet. Die Verbindungsleitung zwischen dem vierten Kondensator 830 und der fünften Diode 840 ist über eine sechste Diode 880 mit der Verbindungsleitung zwischen dem siebten Widerstand 860 und der Zenerdiode 870 verbunden. Weiterhin ist zwischen der Verbindungsleitung zwischen dem siebten Widerstand 860 und der Zenerdiode 870 und der zweiten Ausgangsleitung 790 ein fünfter Kondensator 890 angeschossen. Am fünften Kondensator 890 wird eine Gleichspannung beispielsweise zum Betrieb von Teilen der elektrischen Schaltung, insbesondere zum Betrieb der Steuereinheit 420 bereitgestellt. Die Gleichspannung kann im Bereich von beispielsweise 6 bis 20 V liegen und wird durch die Zenerdiode 870 festgelegt. Die fünfte und die sechste Diode 840, 880 sind als schnelle Dioden ausgebildet. Der vierte Kondensator 830 reduziert die zeitliche Spannungsänderung und die Schaltverluste. Durch die Wahl der Zenerdiode 870 wird die gewünschte Höhe der Gleichspannung festgelegt. Der fünfte Kondensator 890 speichert die Gleichspannung, die über die Zenerdiode 870 bereitgestellt wird. Zu jeder Zeit, zu der der Inverter in Form des ersten und des zweiten Schalters 710, 720 aktiviert wird, wird die gewünschte Gleichspannung am Ausgang des fünften Kondensators 890 bereitgestellt. Mithilfe des siebten Widerstandes 860 wird eine Aufweckschaltung für die elektrische Versorgung der Schaltung bereitgestellt. Somit wird auf diese Weise die benötigte Spannung bereitgestellt, bevor der Inverter aktiviert wird. Dies wird dadurch erreicht, dass die Zenerdiode rückwärts invers gepolt wird.

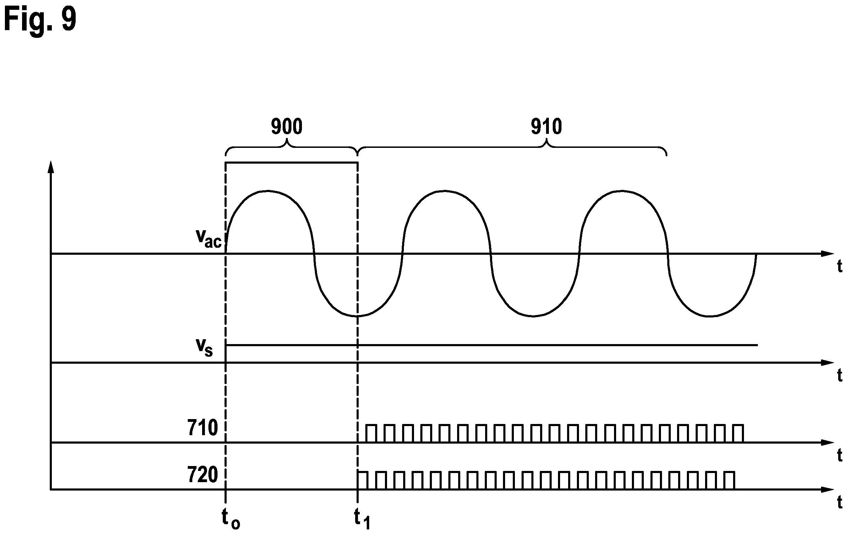

Fig. 9 zeigt ein Diagramm, das das zeitliche Verhalten der Spannungsverläufe der Schaltung der Fig. 8 darstellt. Bei einer Startphase 900 erzeugt die Wechselspannungsquelle 600 zu einem Zeitpunkt T0 eine Wechselspannung. Dadurch wird am fünften Kondensator 890 eine Versorgungsspannung Vs von beispielsweise 12 V bereitgestellt. Erst nach Ablauf einer vorgegebenen Startphase 900 beginnen zum Zeitpunkt T1 die Schalter 710, 720 während einer normalen Betriebsphase 910 zu schalten.

### Bezugszeichenliste

- 100: Multischmelzvorrichtung
- 110: Multischmelzgerät
- 112: Materialstift
- 114: Stiftgehäuse
- 116: Zuführabschnitt
- 118: Halteabschnitt
- 120: Ringspalt
- 122: Aufnahmeschacht
- 200: Heizstation
- 202: Halterung
- 210: Induktivheizung
- 220: erste Heizwicklung
- 222: zweite Heizwicklung
- 224: Heizdüse
- 226: Austrittsöffnung
- 228: Vorheizhülse
- 270: Steuereinrichtung
- 290: elektrische Schaltung
- 300: Messschaltung
- 310: Wechselspannungsquelle
- 320: erster elektrischer Widerstand
- 330: zweiter elektrischer Widerstand
- 340: dritter elektrischer Widerstand
- 350: erster elektrischer Kontakt
- 360: zweiter elektrischer Kontakt
- 370: Spannungsmessgerät
- 380: weitere elektrische Schaltung
- 390: weiterer erster elektrischer Kontakt
- 400: weiterer zweiter elektrischer Kontakt
- 410: Messwiderstand
- 415: Messspule
- 420: Steuereinheit
- 430: Strommesseinrichtung
- 440: erste Feder
- 450: zweite Feder
- 510: dritter elektrischer Widerstand
- 511: weiterer dritter elektrischer Widerstand
- 512: weiterer dritter elektrischer Widerstand
- 520: vierter elektrischer Widerstand
- 530: Sendespule
- 540: Drehregler
- 600: zweite Wechselspannungsquelle
- 610: EMC-Filter
- 620: erste Serienschaltung
- 630: erste Diode
- 640: zweite Diode
- 650: zweite Serienschaltung
- 660: dritte Diode
- 670: vierte Diode
- 680: erste Busleitung
- 690: zweite Busleitung
- 700: erster Kondensator
- 710: erster Schalter
- 720: zweiter Schalter
- 730: Verbindungsleitung
- 740: zweite Sendespule
- 750: ohmscher Widerstand
- 760: induktiver Widerstand
- 770: zweiter Kondensator
- 780: erste Ausgangsleitung
- 790: zweite Ausgangsleitung
- 800: dritte Ausgangsleitung
- 810: dritter Kondensator
- 820: weitere Serienschaltung
- 830: vierter Kondensator
- 840: fünfte Diode
- 850: zusätzliche Serienschaltung
- 860: siebter Widerstand
- 870: Zenerdiode
- 880: sechste Diode
- 890: fünfter Kondensator
- 900: Startphase
- 910: Betriebsphase
- 950: Versorgungsschaltung

## Patentansprüche

1. Vorrichtung zum Erfassen einer Temperatur und/oder einer Heizleistung eines Multischmelzgerätes (110)
mit einer elektrischen Schaltung (290), die ausgebildet ist, um die Temperatur des Multischmelzgerätes (110) zu erfassen, wobei die elektrische Schaltung (290) ausgebildet ist, um mit einer weiteren elektrischen Schaltung (380) des Multischmelzgerätes (110) induktiv verbunden zu werden, mit einer Messschaltung (300), die ausgebildet ist, um einen Strom und/oder eine Spannung der elektrischen Schaltung (290) zu messen, und mit einer Auswerteschaltung (420), die ausgebildet ist, um abhängig von der gemessenen Spannung und/oder abhängig von dem gemessenen Strom die Temperatur des Multischmelzgerätes (110) zu ermitteln, wobei die elektrische Schaltung (290) ausgebildet ist, um das
Multischmelzgerät (110) induktiv mit Heizleistung zu versorgen, **dadurch gekennzeichnet, dass** die elektrische Schaltung (290) einen Gleichrichter (630, 640, 660, 670) und einen Wechselrichter (710, 720) aufweist, wobei der Gleichrichter (630, 640, 660, 670) über zwei Busleitungen (680, 690) den Wechselrichter (710, 720) mit Strom versorgt, wobei der Wechselrichter (710, 720) ausgebildet ist, um eine Wechselspannung zum Versorgen einer Sendespule (740) zu erzeugen, wobei die Auswerteschaltung (420) die Spannung zwischen den Busleitungen (680, 690) erfasst, um eine auf das Multischmelzgerät (110) übertragene Heizleistung und/oder eine Temperatur des Multischmelzgerätes (110) abzuschätzen.

2. Vorrichtung nach Anspruch 1, **dadurch gekennzeichnet, dass** die Auswerteschaltung (420) ausgebildet ist, um abhängig von einem zeitlichen Verlauf und/oder von einem minimalen Wert der gemessenen Spannung die induktiv übertragene Heizleistung und/oder die Temperatur des Multischmelzgerätes (110) zu ermitteln.

3. Vorrichtung nach einem der vorhergehenden Ansprüche, wobei die elektrische Schaltung (290) wenigstens einen Messwiderstand (510) zur Messung der Spannung und/oder des Stroms aufweist, wobei die elektrische Schaltung ausgebildet ist, um den wenigstens einen Messwiderstand (510, 511, 512) der elektrischen Schaltung zu ändern.

4. Vorrichtung nach Anspruch 1, wobei die Auswerteschaltung (420) ausgebildet ist, um abhängig von einer Änderung der Spannung zwischen den Busleitungen (680, 690), insbesondere abhängig von einem zeitlichen Verlauf der Spannung, insbesondere abhängig von einer minimalen Spannung die übertragene Heizleistung und/oder die Temperatur des Multischmelzgerätes (110) abzuschätzen.

5. Vorrichtung nach einem der Ansprüche 1 bis 3, wobei der Wechselrichter (710, 720) eine erste Serienschaltung mit zwei Schaltern aufweist, wobei die erste Serienschaltung zwischen den zwei Schaltern eine zweite Ausgangsleitung (780) aufweist, wobei die erste Serienschaltung nach dem zweiten Schalter eine dritte Ausgangsleitung (790) aufweist, wobei die zweite Ausgangsleitung mit einem ersten Anschluss einer Sendespule (740) verbunden ist, wobei die dritte Ausgangsleitung über einen Kondensator (770) mit einem zweiten Anschluss der Sendespule (740) verbunden ist.

6. Vorrichtung nach einem der Ansprüche 1 bis 3, wobei der Wechselrichter (710, 720) eine erste Serienschaltung mit zwei Schaltern (710, 720) aufweist, wobei die erste Serienschaltung vor dem ersten Schalter (710) eine dritte Ausgangsleitung (800) aufweist, wobei die erste Serienschaltung zwischen den zwei Schaltern eine zweite Ausgangsleitung (780) aufweist, wobei die erste Serienschaltung nach dem zweiten Schalter (720) eine erste Ausgangsleitung (780) aufweist, wobei die zweite Ausgangsleitung (780) mit einem ersten Anschluss einer Sendespule (740) verbunden ist, wobei die erste und die dritte Ausgangsleitung (800, 790) mit einem zweiten Anschluss der Sendespule (740) verbunden sind, wobei zwischen der ersten und der zweiten Ausgangsleitung eine Versorgungsschaltung (950) ausgebildet ist, wobei die Versorgungsschaltung (950) eine zweite Serienschaltung aufweist, wobei die zweite Serienschaltung einen ersten Kondensator (830) und eine erste Diode (840) aufweist, wobei die zweite Serienschaltung mit der ersten und der zweiten Ausgangsleitung (790, 780) verbunden ist, wobei zwischen dem Kondensator (830) und der ersten Diode (840) eine erste Versorgungsleitung angeschlossen ist, wobei die erste Versorgungsleitung an einen ersten Anschluss einer zweiten Diode (880) angeschlossen ist, wobei eine Parallelschaltung mit einer Zenerdiode (870) und einem zweiten Kondensator (890) vorgesehen ist, wobei die Parallelschaltung mit einem ersten Anschluss an einen zweiten Anschluss der zweiten Diode angeschlossen ist, wobei die Parallelschaltung mit einem zweiten Anschluss an die erste Ausgangsleitung (790) angeschlossen ist, wobei ein elektrischer Widerstand (860) zwischen dem zweiten Anschluss der zweiten Diode und der dritten Ausgangsleitung geschaltet ist, wobei zwischen dem zweiten Anschluss der zweiten Diode und der ersten Ausgangsleitung (790) eine Gleichspannung bereitgestellt wird.

7. Multischmelzgerät (110) nach einem der vorhergehenden Ansprüche, mit einer weiteren elektrischen Schaltung (380) und einem induktiven Heizelement (224) zum Erwärmen eines Schmelzmaterials, wobei die weitere elektrische Schaltung (380) wenigstens einen Messwiderstand (410) aufweist, der induktiv mit einer elektrischen Schaltung (290) einer Vorrichtung zum induktiven Versorgen eines mobilen Multischmelzgerätes mit Heizleistung und/oder zum Erfassen einer Temperatur des Multischmelzgerätes verbindbar ist.

8. Verfahren zum Erfassen einer Temperatur eines Multischmelzgerätes nach einem der vorhergehenden Ansprüche, wobei eine elektrische Schaltung in Wirkverbindung mit einer weiteren elektrischen Schaltung des Multischmelzgerätes gebracht wird, wobei ein Strom und/oder eine Spannung der elektrischen Schaltung erfasst wird, und wobei abhängig von der gemessenen Spannung und/oder von dem gemessenen Strom eine Temperatur des Multischmelzgerätes ermittelt wird, wobei die elektrische Schaltung das Multischmelzgerät induktiv mit Heizleistung versorgt, **dadurch gekennzeichnet, dass** die elektrische Schaltung einen Gleichrichter aufweist, wobei der Gleichrichter über zwei Busleitungen einen Wechselrichter mit Strom versorgt, wobei der Wechselrichter ausgebildet ist, um eine Wechselspannung zum Versorgen einer elektrischen Spule zu erzeugen, wobei die Spannung zwischen den Busleitungen erfasst wird, um abhängig von der Spannung die Temperatur des Multischmelzgerätes und/oder die auf das Multischmelzgerät übertragene Heizleistung abzuschätzen.

9. Verfahren nach Anspruch 8, , wobei abhängig von einer Phasenverschiebung zwischen Strom und Spannung eine Temperatur des Multischmelzgerätes ermittelt wird.

10. Verfahren nach einem der Ansprüche 8 oder 9, wobei ein Messwiderstand der elektrischen Schaltung verändert wird, um einen anderen Messbereich einzustellen.

## Claims

1. Apparatus for measuring a temperature and/or a heating power of a multi-purpose melting device (110), having an electrical circuit (290) which is designed to measure the temperature of the multi-purpose melting device (110), wherein the electrical circuit (290) is designed to be inductively connected to a further electrical circuit (380) of the multi-purpose melting device (110), having a measuring circuit (300) which is designed to measure a current and/or a voltage of the electrical circuit (290), and having an evaluation circuit (420) which is designed to determine the temperature of the multi-purpose melting device (110) on the basis of the measured voltage and/or on the basis of the measured current, wherein
the electrical circuit (290) is designed to inductively supply heating power to the multi-purpose melting device (110), **characterized in that** the electrical circuit (290) has a rectifier (630, 640, 660, 670) and an inverter (710, 720), wherein the rectifier (630, 640, 660, 670) supplies power to the inverter (710, 720) via two bus lines (680, 690), wherein the inverter (710, 720) is designed to produce an AC voltage for supplying power to a transmitter coil (740), wherein the evaluation circuit (420) measures the voltage between the bus lines (680, 690) in order to estimate a heating power transmitted to the multi-purpose melting device (110) and/or a temperature of the multi-purpose melting device (110).

2. Apparatus according to Claim 1, **characterized in that** the evaluation circuit (420) is designed to determine the inductively transmitted heating power and/or the temperature of the multi-purpose melting device (110) on the basis of a time characteristic and/or of a minimum value of the measured voltage.

3. Apparatus according to either of the preceding claims, wherein the electrical circuit (290) has at least one measuring resistor (510) for measuring the voltage and/or the current, wherein the electrical circuit is designed to alter the at least one measuring resistor (510, 511, 512) of the electrical circuit.

4. Apparatus according to Claim 1, wherein the evaluation circuit (420) is designed to estimate the transmitted heating power and/or the temperature of the multi-purpose melting device (110) on the basis of a change in the voltage between the bus lines (680, 690), in particular on the basis of a time characteristic of the voltage, in particular on the basis of a minimum voltage.

5. Apparatus according to one of Claims 1 to 3,
wherein the inverter (710, 720) has a first series circuit comprising two switches, wherein the first series circuit has a second output line (780) between the two switches, wherein the first series circuit has a third output line (790) downstream of the second switch, wherein the second output line is connected to a first terminal of a transmitter coil (740), wherein the third output line is connected to a second terminal of the transmitter coil (740) via a capacitor (770).

6. Apparatus according to one of Claims 1 to 3,
wherein the inverter (710, 720) has a first series circuit comprising two switches (710, 720), wherein the first series circuit has a third output line (800) upstream of the first switch (710), wherein the first series circuit has a second output line (780) between the two switches, wherein the first series circuit has a first output line (780) downstream of the second switch (720), wherein the second output line (780) is connected to a first terminal of a transmitter coil (740), wherein the first and third output lines (800, 790) are connected to a second terminal of the transmitter coil (740), wherein a power-supply circuit (950) is formed between the first and the second output line, wherein the power-supply circuit (950) has a second series circuit, wherein the second series circuit has a first capacitor (830) and a first diode (840), wherein the second series circuit is connected to the first and second output lines (790, 780), wherein a first power-supply line is connected between the capacitor (830) and the first diode (840), wherein the first power-supply line is connected to a first terminal of a second diode (880), wherein a parallel circuit comprising a Zener diode (870) and a second capacitor (890) is provided, wherein a first terminal of the parallel circuit is connected to a second terminal of the second diode, wherein a second terminal of the parallel circuit is connected to the first output line (790), wherein an electrical resistor (860) is connected between the second terminal of the second diode and the third output line, wherein a DC voltage is provided between the second terminal of the second diode and the first output line (790).

7. Multi-purpose melting device (110) according to one of the preceding claims, having a further electrical circuit (380) and an inductive heating element (224) for heating a melting material, wherein the further electrical circuit (380) has at least one measuring resistor (410) which is able to be inductively connected to an electrical circuit (290) of an apparatus for inductively supplying heating power to a mobile multi-purpose melting device and/or for measuring a temperature of the multi-purpose melting device.

8. Method for measuring a temperature of a multi-purpose melting device according to one of the preceding claims, wherein an electrical circuit is brought into operative connection with a further electrical circuit of the multi-purpose melting device, wherein a current and/or a voltage of the electrical circuit is measured, and wherein a temperature of the multi-purpose melting device is determined on the basis of the measured voltage and/or of the measured current,
wherein the electrical circuit inductively supplies heating power to the multi-purpose melting device, **characterized in that** the electrical circuit has a rectifier, wherein the rectifier supplies power to an inverter via two bus lines, wherein the inverter is designed to produce an AC voltage for supplying power to an electric coil, wherein the voltage between the bus lines is measured in order to estimate the temperature of the multi-purpose melting device and/or the heating power transmitted to the multi-purpose melting device, on the basis of the voltage.

9. Method according to Claim 8, wherein a temperature of the multi-purpose melting device is determined on the basis of a phase shift between current and voltage.

10. Method according to either of Claims 8 and 9, wherein a measuring resistor of the electrical circuit is altered to set a different measuring range.

## Revendications

1. Dispositif permettant de détecter une température et/ou une puissance de chauffage d'un appareil de fusion multiple (110), comprenant un circuit électrique (290) qui est réalisé pour détecter la température de l'appareil de fusion multiple (110), le circuit électrique (290) étant réalisé pour être relié par induction à un circuit électrique supplémentaire (380) de l'appareil de fusion multiple (110), comprenant un circuit de mesure (300) qui est réalisé pour mesurer un courant et/ou une tension du circuit électrique (290), et comprenant un circuit d'évaluation (420) qui est réalisé pour déterminer la température de l'appareil de fusion multiple (110) en fonction de la tension mesurée et/ou en fonction du courant mesuré, dans lequel
le circuit électrique (290) est réalisé pour alimenter l'appareil de fusion multiple (110) en puissance de chauffage par induction, **caractérisé en ce que** le circuit électrique (290) présente un redresseur (630, 640, 660, 670) et un onduleur (710, 720), dans lequel le redresseur (630, 640, 660, 670) alimente l'onduleur (710, 720) en courant par l'intermédiaire de deux lignes de bus (680, 690), l'onduleur (710, 720) étant réalisé pour générer une tension alternative pour l'alimentation d'une bobine émettrice (740), dans lequel le circuit d'évaluation (420) détecte la tension entre les lignes de bus (680, 690) pour estimer une puissance de chauffage transmise à l'appareil de fusion multiple (110) et/ou une température de l'appareil de fusion multiple (110).

2. Dispositif selon la revendication 1, **caractérisé en ce que** le circuit d'évaluation (420) est réalisé pour déterminer la puissance de chauffage transmise par induction et/ou la température de l'appareil de fusion multiple (110) en fonction de l'évolution dans le temps et/ou d'une valeur minimale de la tension mesurée.

3. Dispositif selon l'une quelconque des revendications précédentes, dans lequel le circuit électrique (290) présente au moins une résistance de mesure (510) pour mesurer la tension et/ou le courant, le circuit électrique étant réalisé pour modifier ladite au moins une résistance de mesure (510, 511, 512) du circuit électrique.

4. Dispositif selon la revendication 1, dans lequel le circuit d'évaluation (420) est réalisé pour estimer la puissance de chauffage transmise et/ou la température de l'appareil de fusion multiple (110) en fonction d'une modification de la tension entre les lignes de bus (680, 690), en particulier en fonction d'une évolution dans le temps de la tension, en particulier en fonction d'une tension minimale.

5. Dispositif selon l'une quelconque des revendications 1 à 3,
dans lequel l'onduleur (710, 720) présente un premier montage en série avec deux commutateurs, dans lequel le premier montage en série présente une deuxième ligne de sortie (780) entre les deux commutateurs, dans lequel le premier montage en série présente une troisième ligne de sortie (790) après le deuxième commutateur, dans lequel la deuxième ligne de sortie est reliée à une première borne d'une bobine émettrice (740), dans lequel la troisième ligne de sortie est reliée à une deuxième borne de la bobine émettrice (740) par l'intermédiaire d'un condensateur (770).

6. Dispositif selon l'une quelconque des revendications 1 à 3,
dans lequel l'onduleur (710, 720) présente un premier montage en série avec deux commutateurs (710, 720), dans lequel le premier montage en série présente une troisième ligne de sortie (800) avant le premier commutateur (710), dans lequel le premier montage en série présente une deuxième ligne de sortie (780) entre les deux commutateurs, dans lequel le premier montage en série présente une première ligne de sortie (780) après le deuxième commutateur (720), dans lequel la deuxième ligne de sortie (780) est reliée à une première borne d'une bobine émettrice (740), dans lequel la première et la troisième ligne de sortie (800, 790) sont reliées à une deuxième borne de la bobine émettrice (740), dans lequel un circuit d'alimentation (950) est réalisé entre la première et la deuxième ligne de sortie, dans lequel le circuit d'alimentation (950) présente un deuxième montage en série, dans lequel le deuxième montage en série présente un premier condensateur (830) et une première diode (840), dans lequel le deuxième montage en série est relié à la première et à la deuxième ligne de sortie (790, 780), dans lequel une première ligne d'alimentation est connectée entre le condensateur (830) et la première diode (840), dans lequel la première ligne d'alimentation est connectée à une première borne d'une deuxième diode (880), dans lequel est prévu un montage en parallèle avec une diode Zener (870) et un deuxième condensateur (890), dans lequel le montage en parallèle est connecté par une première borne à une deuxième borne de la deuxième diode, dans lequel le montage en parallèle est connecté par une deuxième borne à la première ligne de sortie (790), dans lequel une résistance électrique (860) est montée entre la deuxième borne de la deuxième diode et la troisième ligne de sortie, dans lequel une tension continue est fournie entre la deuxième borne de la deuxième diode et la première ligne de sortie (790).

7. Appareil de fusion multiple (110) selon l'une quelconque des revendications précédentes, comprenant un circuit électrique supplémentaire (380) et un élément chauffant inductif (224) pour réchauffer une matière fusible, dans lequel le circuit électrique supplémentaire (380) présente au moins une résistance de mesure (410) qui peut être reliée par induction à un circuit électrique (290) d'un dispositif pour l'alimentation par induction d'un appareil de fusion multiple en puissance de chauffage et/ou pour détecter une température de l'appareil de fusion multiple.

8. Procédé permettant de détecter une température d'un appareil de fusion multiple selon l'une quelconque des revendications précédentes, dans lequel un circuit électrique est amené en relation active avec un circuit électrique supplémentaire de l'appareil de fusion multiple, dans lequel un courant et/ou une tension du circuit électrique sont détectés, et dans lequel une température de l'appareil de fusion multiple est déterminée en fonction de la tension mesurée et/ou du courant mesuré,
dans lequel le circuit électrique alimente l'appareil de fusion multiple en puissance de chauffage par induction, **caractérisé en ce que** le circuit électrique présente un redresseur, dans lequel le redresseur alimente un onduleur en courant par l'intermédiaire de deux lignes de bus, dans lequel l'onduleur est réalisé pour générer une tension alternative pour alimenter une bobine électrique, dans lequel la tension entre les lignes de bus est détectée pour estimer la température de l'appareil de fusion multiple en fonction de la tension et/ou la puissance de chauffage transmise à l'appareil de fusion multiple.

9. Procédé selon la revendication 8, dans lequel une température de l'appareil de fusion multiple est déterminée en fonction d'un déphasage entre le courant et la tension.

10. Procédé selon l'une quelconque des revendications 8 ou 9, dans lequel une résistance de mesure du circuit électrique est modifiée pour régler une autre plage de mesure.
